# EUROPEAN PATENT SPECIFICATION

(11) **EP 2 081 424 B1**
(45) Date of publication and mention of the grant of the patent: **17.04.2013**
(21) Application number: 09000783.2
(22) Date of filing: 21.01.2009
(51) Int. Cl.: H05K 13/04

(54) **Installation head actuator for electronic parts and installation device for electronic parts**
Installationskopfaktuator und Installationsvorrichtung für elektronische Bauteile
Installation d'actionneur de tête et dispositif d'installation pour pièces électroniques

(30) Priority: 21.01.2008 JP 2008010090
(43) Date of publication of application: 22.07.2009
(73) Proprietor: Hitachi High-Tech Instruments Co., Ltd., Kumagaya-shi Saitama 360-0238 (JP)
(72) Inventor: Takahira, Isao, Tokyo 100-8220 (JP); Kashitani, Hisayoshi, Gunma 373-0806 (JP); Urata, Naoki, Ora-gun Gunma 370-0532 (JP)
(74) Representative: Beetz & Partner

(56) References cited:
- EP-A1- 0 854 670
- EP-A2- 0 821 549
- US-A1- 2006 196 046

## Description

### BACKGROUND OF THE INVENTION

The present invention relates to an installation head actuator for electronic parts, for taking out electronic parts by a suction nozzle, so as to install them on a printed circuit board, and also an installation device for electronic parts with using the same therein.

Conventionally, when installing the electronic parts on the printed circuit board, an installation device is applied, i.e., for picking up the electronic parts from a parts supply unit, by the suction nozzle, and thereby installing them on the printed circuit board.

For example, in the installation device for electronic parts described in the following Patent Document 1, an installation head actuator equipped with plural numbers of suction nozzles, after sucking the electronic parts, moves to a position above the printed circuit board, and installs them at predetermined positions. In case when sucking the electronic part onto one (1) nozzle from a group of nozzles (hereinafter, a nozzle group), which are aligned in a ring-like manner, the nozzle group turns around a rotation shaft of the head actuator equipped with the suction nozzles, and when the corresponding nozzle reaches to the predetermined position, this suction nozzle is moved downward where there is the parts supply unit, so as to suck an electronic part thereon, with using a vacuum or the like. Next, after sucking, the suction nozzle is moved upwards to a predetermined waiting position (or height). Thereafter, the nozzle group is revolved so as to select the suction nozzle corresponding to the electric part to be installed next. Thus, when conducting the suction operation corresponding to a predetermined electronic part, only the suction nozzle moves up/down, corresponding to the size of that electronic part, in the structures thereof. This operation is also same when installing the electronic parts.

[Patent Document 1] Japanese Patent Laying-Open No. 2005-228992 (2005).

Documents EP 0821549 A2 and EP 0854 670 Aldisclose devices according to the preamble of claim 1 respectively. US 2006/0196046 A1 discloses a device with a ring shaped arrangement of suction nozzles.

### BRIEF SUMMARY OF THE INVENTION

By the way, for such the installation device for electronic parts, a demand requested upon throughput of installation of the electronic parts is in a tendency of increasing, every year, and further is requested high installation accuracy of the electronic parts, for preventing from production of a printed circuit board, having a poor or mal-circuit due to defects when installing the electronic parts thereon.

However, with the technology described in the Patent Document 1, because a motor is applied, also to select the suction nozzle, due to the operational limit and the mechanical restriction, etc., of the motor, which can be installed in the installation head actuator, there is a limitation, in particular, for increasing the throughput thereof. Also, because of an increase of operating speed of the motor, vibrations come to be large, which are caused due to contact and/or interference generating during parallel operation thereof, and generating slip-out of shifting of a chip, therefore it is the greatest reason of generating the mal-circuit in the printed circuit boards.

By taking the problems mentioned above into the consideration thereof, according to the present invention, an object thereof is to provide an installation device for electronic parts having a high reliability, while increasing the throughput by maximizing the parallel operation of the motor, etc., and reducing the contacts and the interferences generating during that parallel operation.

For accomplishing the object mentioned above, according to the present invention, first of all, there is provided an electronic parts installation head actuator according to claim 1, which may comprise: a plural number of suction nozzles, each of which is configured to suck an electronic part to install it on a printed circuit board; a nozzle selector member, which is configured to hold said plural number of suction nozzles and to select a predetermined suction nozzle; and an elevating device, which is configured to elevate saidplural number of suction nozzles, wherein when said predetermined nozzle is selected, said nozzle selector member detaches said predetermined suction nozzle, electro-magnetically, from said plural number of suction nozzles, and thereby conducts selecting.

Said nozzle selector member has a permanent magnet attracting said suction nozzle, which is biased in a downward direction by an elastic body and an exciting coil for neutralizing the magnetic force of said permanent magnet by applying current therein.

Further, according to the present invention, within the electronic parts installation head actuator, as described in the above, said plural number of suction nozzles are disposed on one (1) ring or a plural number of rings, circularly.

Further, according to the present invention, the electronic parts installation head actuator, as described in the above, further comprising: a nozzle support member, which is configured to support said plural number of suction nozzles; and a rotating device, which is configured to rotate said nozzle support member a vertical axial line.

Further, according to the present invention, within the electronic parts installation head actuator, as described in the above, said elevating device and said rotating device are operated, simultaneously, and thereby enabling parallel operation thereof.

Further, according to the present invention, within the electronic parts installation head actuator, as described in the above, said plural number of suction nozzles are disposed on one (1) line or a plural number of lines, linearly.

Further, according to the present invention, there is provided an electronic parts installation device according to claim 7, which may comprise: a plural number of parts supply units, each of which is configured to supply an electronic part at a part sucking position; a beammovable between each part supply unit and a printed circuit board; and an electronic parts installation head actuator, being movable along said bean and movable in X-Y direction, wherein said electronic parts installation head actuator is the electronic parts installation actuator described in the above.

### BRIEF DESCRIPTION OF THE SEVERAL VIEWS OF THE DRAWING

Those and other objects, features and advantages of the present invention will become more readily apparent from the following detailed description when taken in conjunction with the accompanying drawings wherein:
Fig. 1 is a plane view for showing an installation device for electronic parts, according to an embodiment of the present invention;
Fig. 2 is a front view of a main body of a lower portion of the installation device for electronic parts mentioned above;
Fig. 3 is a control block diagram of the installation device for electronic parts mentioned above;
Fig. 4 is a front view of vertical cross-section of a head actuator of the installation device for electronic parts mentioned above;
Fig. 5 is an enlarged front view of vertical cross-section of an upper portion of a suction nozzle of the head actuator of the device shown in Fig. 4;
Fig. 6 is a view for explaining elevation of the suction nozzle mentioned above;
Fig. 7 is an outlookbottomview of the head actuator mentioned above;
Fig. 8 is a view for showing the relationship between the elevating operation of the suction nozzle and rotating operation of a nozzle rotating motor;
Figs. 9A and 9B are views for showing decent of the suction nozzle mentioned above;
Fig. 10 is a flowchart for carrying back an electronic part of the installation device for electronic parts mentioned above;
Fig. 11 is a view for showing an example of other disposition of suction nozzles of the installation device for electronic parts mentioned above; and
Figs. 12A and 12B are view for showing an example of further other disposition of suction nozzles of the installation device for electronic parts mentioned above.

### DETAILED DESCRIPTION OF THE PREFERRED EMBODIMENTS

Hereinafter, embodiments according to the present invention will be fully explained by referring to the attached drawings.

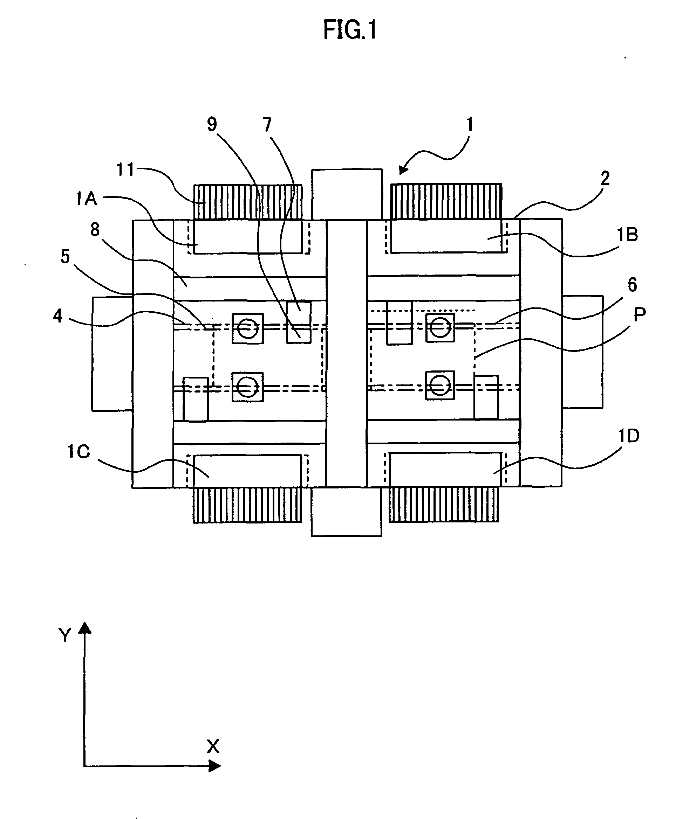

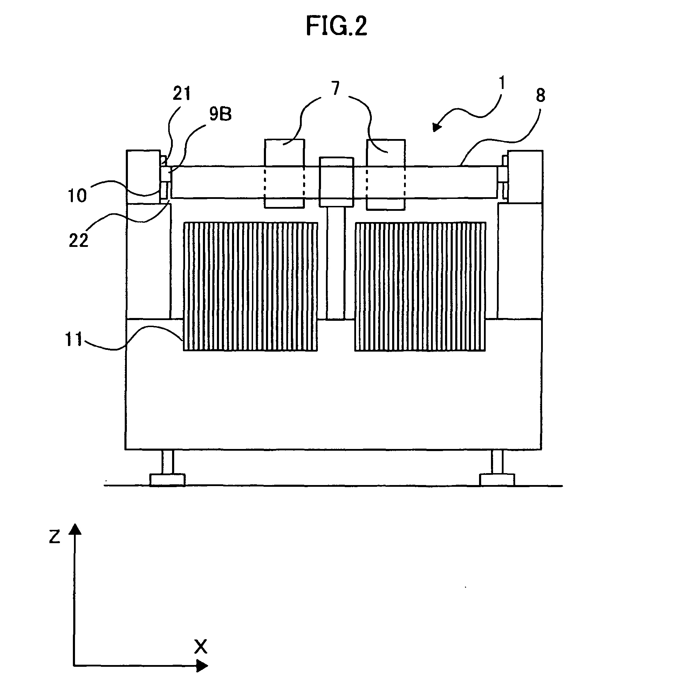

Fig. 1 attached herewith is a front view of an installation device 1 for electronic parts (hereinafter, an electronic parts installation device), according to an embodiment of the present invention. Fig. 2 is a front view of a main body of a lower portion of the electronic parts installation device 1. Upon feeder basses 1A, 1B, 1C and 1D on a base 2 of the electronic parts installation device 1 are fixed plural numbers of parts supply units 11 in parallel with, respectively, each for supplying various kinds of electronic parts "D" to a part takeout position (i. e. , a part suction position), one by one, under an immovable condition, but in a detachable manner. Between groups of the units facing to each other is provided a supply conveyer 4, a positioning unit 5 and a discharge conveyer 6. The supply conveyer 4 transfers a printed circuit board "P", which is sent from an upper stream of a manufacturing line to the positioning unit 5 one by one, and after being installed with the electronic parts D thereon by means of a positioning mechanism not shown in the figure, within the positioning unit 5, the printed circuit board "P" is transferred to the discharge conveyer 6.

A reference numeral 8 depicts a pair of beams, which are long in an X-direction, and on each beam 8 is provided an installation head body 7, which can move in the X-direction along a guide by means of a liner motor provide into the X-direction.

The beams 8 can move in a Y-direction, respectively, above the printed circuit board "P" on the positioning unit 5 and the part takeout position (i.e., the part suction position) of the parts supply units 11, while sliding a slider 9B fixed to each of the beams 9 along a pair of guides provided on both sides, which is driven by each of the linear motors 21. The linear motor 21 is built up with a pair of stators, which are fixed on the base 2, and a rotor fixed on a lower portion of an attachment plate, which is provided on both sides of the beam 8 mentioned above.

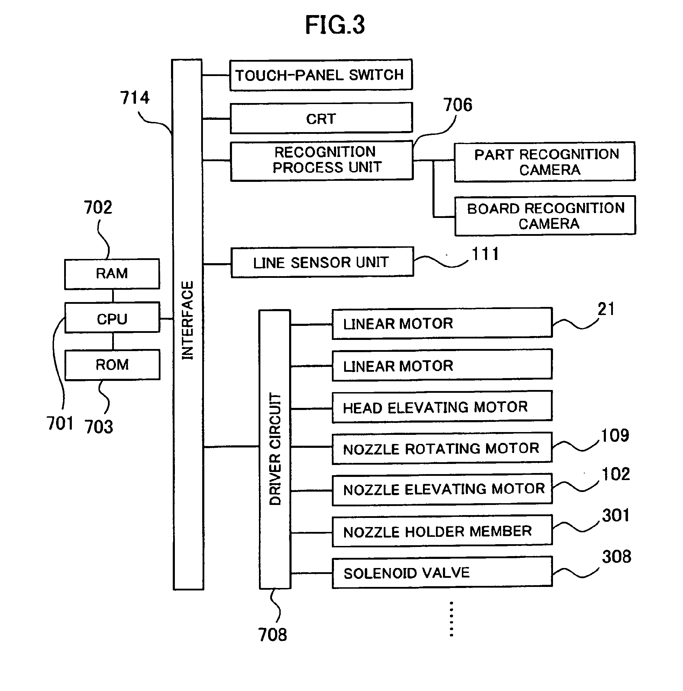

Fig. 3 attached herewith is a control block diagram of the installation device for electronic parts mentioned above. A reference numeral 701 depicts a CPU (i.e., an installation controller unit) as a controller portion for generally controlling the electronic parts installation device 1. With the CPU 701 are connected a RAM (Random Access Memory) 702 and a ROM (Read Only Memory) 703, through a bus line. And, the CPU 701 controls the operations, generally, in relation to installations of the parts of the electronic parts installation device 1, in accordance with programs stored within the ROM 703, upon basis of data memorized in the RAM 703. Thus, the CPU 701 controls the driving of the linear motors 21, a head elevating motor, a nozzle rotating motor 109, a nozzle elevating motor 102, a nozzle holder member 301 and a solenoid valve 308, etc.

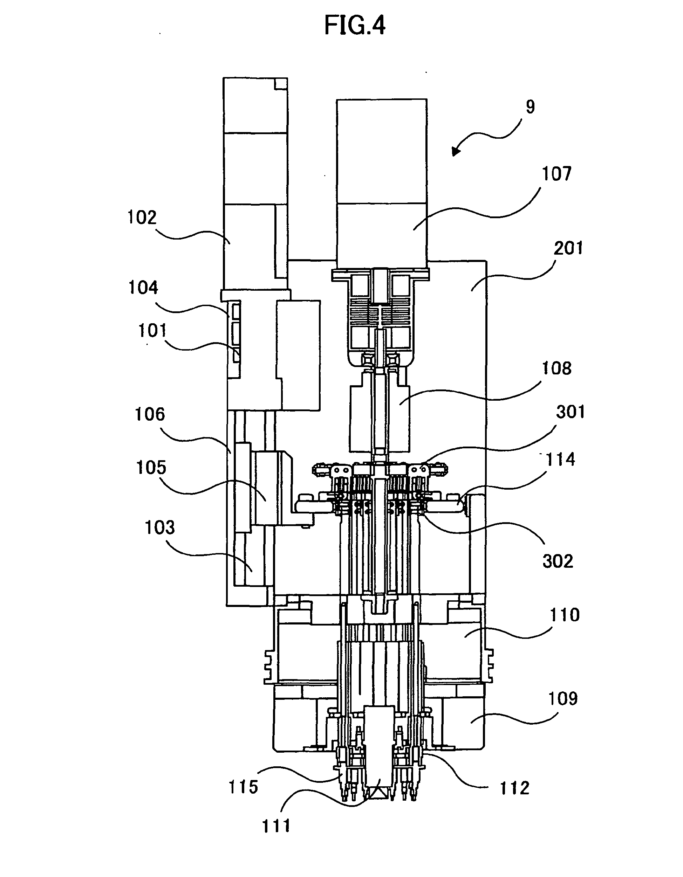

Fig. 4 attached herewith is a front view of the vertical cross-section of an installation head actuator of the installation device for electronic parts mentioned above. Each of the installation head bodies 7 has an installation head actuator 9, including a suction nozzle 115 biased downwards, respectively, by a spring 112, which is provided in a lower portion thereof. And, on each installation head actuator 9 of each installation head body 7 is provided a board recognition camera (not shown in the figure), for photographing a mark (not shown in the figure), which is attached on the printed circuit board "P" positioned on the positioning unit 5.

A slip ring 107 is provided to prevent wires lying between the electronic parts installation device 1 and the installation head actuator 9 from being cut-off, and further for the purpose of electric power transmission and information communication. A rotary joint 108 is provided for applying a vacuum or a positive pressure to the suction nozzles 115, also during the time when they are in the operation of rotating. A reference numeral 109 depicts the nozzle rotating motor 109 for θ rotation, for rotating a rotor 110 around an axis at the center of the installation head actuator 9. The rotor 110 also functions as a nozzle supporting member.

A reference numeral 111 depicts a line sensor unit, projecting downward from the center of the installation head actuator 9, as a detector means for detecting presence/absence of a part and a sucking posture, and also as a detector means for detecting a lower end position of the suction nozzle. This line sensor unit 111 is constructed with a light emitting unit, which is built up by disposing a reflector having a conical reflecting surface, and a light receiving unit, which comprises a plural number of light receiving units or elements, i.e., CCD elements.

A reference numeral 101 depicts a nozzle elevating device, which is provided on the installation head actuator 9. A reference numeral 102 depicts amotor for use of nozzle elevation (hereinafter, being called the "nozzle elevating motor"), which is provided on a base 201 on the head actuator side. A reference numeral 103 depicts a motive power transmitting member (for example, it may be a ball screw, etc.), being connected with a rotation shaft of the nozzle elevating motor 102 through a coupling member 104, to be driven rotationally by the nozzle elevating motor 102, and a reference numeral 105 depicts an elevating body, spirally jointing with that motive power transmitting member 103, to elevate through rotation of that motive power transmitting member 103. A numeral reference 106 depicts a guide, being attached on the base 201 on the head actuator side for guiding the elevation of the elevating body 105.

A reference numeral 114 depicts a nozzle base, which is attached on the elevating body 105 mentioned above. This nozzle base 114 is used when elevating the nozzle. However, the spring 112 may be attached so as to apply the restoring force thereof directing upward, so that the suction nozzle may return by the force of that spring when the suction nozzle goes up.

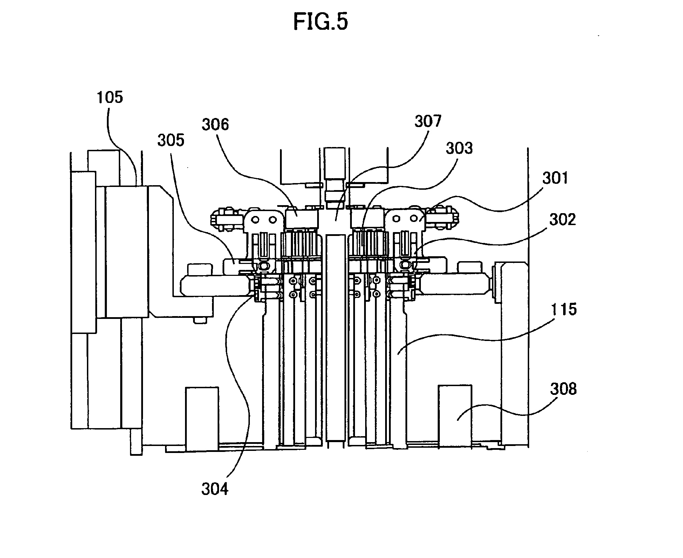

Fig. 5 attached herewith an enlarged front view of the vertical cross-section of an upper portion of the suction nozzle of the installation head actuator shown in Fig. 4. A reference numeral 308 depicts an air exchanger valve being provided at a position outer than each of the suction nozzles 115, in the peripheral direction, corresponding to each of the suction nozzles 115, at an equal angular distance therebetween, which can be switched or exchanged separately. This air exchanger valve 308 is made up with a case that is provided in an upper portion thereof, and a solenoid valve, an upper portion thereof being positioned within that case, and current conduction thereof being controlled by a signal from the CPU 701. The solenoid valve is built up with a ring-like electromagnet, which is provided on an interior surface of the case, and a passage exchanger body, elevating within the case depending on conduction/non-conduction of current into that electromagnet, and being provided with a cylindrical permanent magnet in an upper portion thereof corresponding to the electromagnet, etc. (but, the contents of the solenoid valve is not shown in the figure). On an outer peripheral surface of the passage exchanger body are formed an air blow passage (hereinafter, being called an "air passage") and a nozzle communicating passage and a passage for evacuating the vacuum (hereinafter, being called a "vacuum passage", in that order from the upper to the lower. Also, in the nozzle shaft is formed a nozzle shaft passage communicating with an inner passage and a nozzle communication passage of the suction nozzle, and through elevation of the passage exchanger body, the communication is switched between the nozzle passage and the vacuum passage or the air passage.

Thus, when the passage exchanger body goes up through current conduction into the electromagnet within the solenoid, the vacuum passage and the nozzle communication passage are communicated, but the nozzle communication passage and the air passage are shut off, and then the inner passage of the suction nozzle communicates with a vacuum source not shown in the figure through the nozzle shaft passage, the nozzle communication passage and the vacuum passage, and thereby enabling the suction nozzle to maintain vacuum absorption of the electronic part "D" thereon. Also, when the electromagnet is in the condition of non-conduction of current therein and the passage exchanger body goes down, then the vacuum passage communicating with the vacuum source and the nozzle communication passage are shut off, and the nozzle communication passage and the air passage are communicated with; thereby an air from an air supply source is blown into the inner passage of the suction nozzle through the air passage, the nozzle communication passage and the nozzle shaft passage, while stopping the vacuum absorption of the electronic part "D" by the suction nozzle.

In this manner, through the conduction/non-conduction of current into the air exchanger valves 308, which are provided corresponding to the suction nozzles 115, respectively, it is possible to switch over the communication between the suction nozzle 115 and the vacuum source or the air supply source, and thereby to exchange the air exchanger valve 308 corresponding to the suction valve 115 selected.

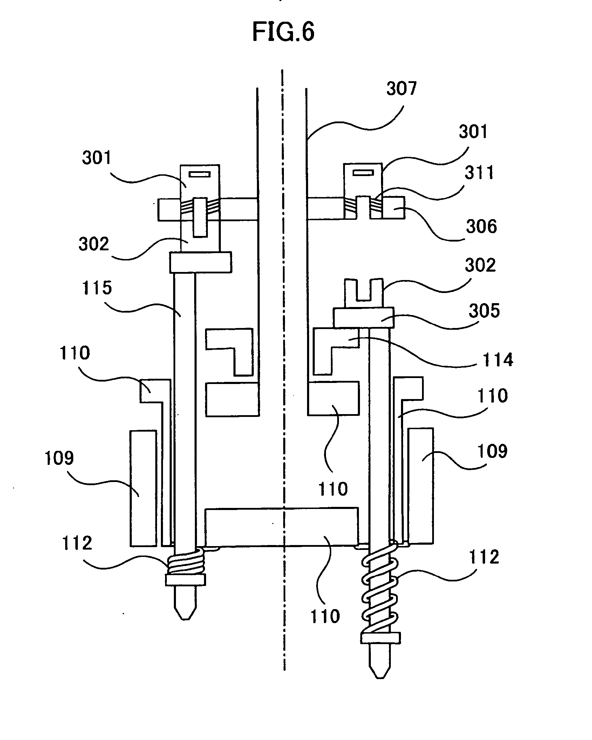

Fig. 6 attached herewith is a view for explaining elevation of the suction nozzle mentioned above. A reference numeral 301 depicts the nozzle holder member (or, a nozzle selector member) for achieving a function of a clutch, i.e., always pulling the suction nozzle 115 upward. In this instance, only one that is pulled up is a movable piece 302, which is provided in an upper portion of the suction nozzle 115. However, in the place of the movable piece 302, it is also possible to shape an upper part of the suction nozzle 115 or a part of a top block 304 attached on the upper part of the suction nozzle 115, into the configuration same to that movable piece. Also, on the nozzle holder member 301 is mounted the permanent magnet (not shown in the figure), and the movable piece 302 is absorbed with using magnetic flux generated by that permanent magnet. The movable piece can be separated, at an arbitrary moment, by supplying current to an exiting coil 311, which is wound around the nozzle holder member 301, thereby to generate the magnetic flux in the direction reverse to that the permanent magnet generates, i.e., neutralizing. (Or, it is also possible to hold the suction nozzle 115 by supplying current to generate the magnetic flux in the same direction to that of the permanent magnet, and thereby increasing the magnetic flux.) Thus, it is also possible to select and separate a plural number of the suction nozzles 115, selectively.

Since the suction nozzle(s) 115 separated from the nozzle holder member 301 is/are biased downward by means of the spring (s) 112, then it/they are pushed down on the nozzle base 114 through a rotatingbody 305, and an arbitrary suction nozzles 115 can elevate, which is/are separated depending upon elevation of the nozzle base 114.

The nozzle holder member 301 is disposed on an upper portion of the suction nozzle 115, respectively, with using a nozzle holder member base 306, and it rotates with rotation of the rotor 110. Therefore, there is no change in a relatively positional relationship between the suction nozzle 115 and the nozzle holder member 301 with respect to the θ direction. In this instance, since the up/down operation and the rotating operation of the suction nozzle 115 are not interfered with each other, therefore it is possible to achieve a parallel operation. Also, there is no interfering member when it conducts the parallel operation.

A part of an outer periphery of a center shaft 307 is in a spline structure, and the nozzle holder member base 306 is transmitted with the rotation of the rotor 110 through the spline structure mentioned above, and thereby rotating together with the rotor 110. Also, as a means for transmitting the rotation of the rotor 110 to the nozzle holder member base 306, it is also possible to transmit the rotation, with using a coupling member for connecting from the rotor 110 to the nozzle holder member base 306.

The part recognition camera is provided by one (1) set, respectively, corresponding to each of the installation head actuators 9, i . e. , four (4) sets in total, on the attachment place of the base, and they photograph all of the electronic parts "D", collectively, which are sucked and held by the plural number of the suction nozzles, for recognizing the positions thereof, in the X- and Y-directions and rotation angle, i.e., each of the electronic parts "D" is sucked and held thereon, how much degree being shifted in the position with respect to the suction nozzle 115; however, each of them is also able to photograph a plural number of the electronic parts "D", simultaneously. Also, the part recognition camera can confirm on whether the electronic part "D" is sucked and held or not by the suction nozzle 115, through photographing it.

Hereinafter, explanation will be made on the detailed operations of suction and installation of the electronic parts "D" by the electronic parts installation device 1 mentioned above.

First of all, the printed circuit boards "P" are brought into the positioning unit 5, from an upper stream device through the supply conveyer 4, and the positioning operation is started by means of the positioning mechanism.

Next, the CPU 701 produces suction sequence data from installation data, which is stored in the RAM 702. Thus, first of all, the CPU 701 executes a data readout process from the installation data, and executes a determining process of suction steps by means of the suction nozzle 115. Then, it determines a parts supply unit 11 for supplying a last electronic part "D" in a chained or series suction operations, and stores disposition coordinates of the last suction position into the RAM 702. Further, it determines the installation coordinate position (i.e., the position of the installation data before correcting the part suction shift) of the electronic part "D" to be installed at first after completing the chained or series suction operations, and stores the coordinates thereon into the RAM 702. Then, it executes the suction operation of the electronic parts "D".

Thus, in accordance with the X and Y coordinate position where the printed circuit board should be installed, the rotation angle position around the vertical axial line and the installation data, disposition numbers or the like of which is designated, which are stored in the RAM 702, the suction nozzle 115 corresponding to a part kind of the electronic part "D" takes out that electronic part "D" to be installed from a predetermined parts supply unit 11. In this instance, the linear motor is controlled by the CPU 701, and then the suction nozzle 115 of each installation head actuator 9 of each installation head body 7 moves to locate above the electronic part "D" at the front of each parts supply unit 11, which stores the electronic part "D" to be installed; however, in the Y-direction, each of the beams 8 moves along a pair of guides 10, being driven by the linear motor 21 through a driver circuit thereof, while in the X-direction, also being driven by the linear motor 21 through the driver circuit thereof, each of the installation head bodies 7 moves along the guides.

Then, since the predetermined one of the parts supply units 11 is already driven, so that it is in the condition that the part can be taken out therefrom at a part suction position, then upon basis of a signal, which is outputted from the CPU 701 through an interface 714 and a driver circuit 708, the head elevating motor rotates so that the installation head actuator 9 goes down to a predetermined height along the guides.

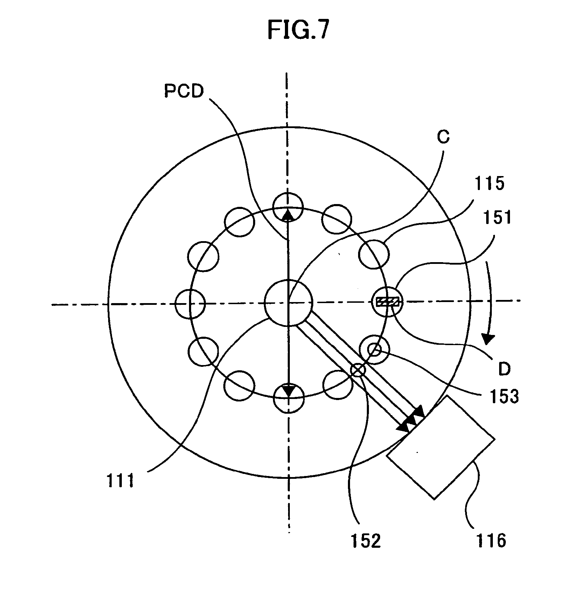

Next, on an outlook bottom view of the head actuator 9 shown in Fig. 7 attached herewith, when the suction nozzle 115, which sucks the electronic part "D" at first (hereinafter, being called a "first suction nozzle") is shifted from the suction position (assuming that this position is "0°"), then the CPU 701 outputs a signal for moving that suction nozzle 115 up to the sucking position 151. With this signal, the nozzle rotating motor 109 rotates. With driving by the nozzle rotating motor 109, the suction nozzle 115 of the installation head actuator 9 rotates around a central axis "C".

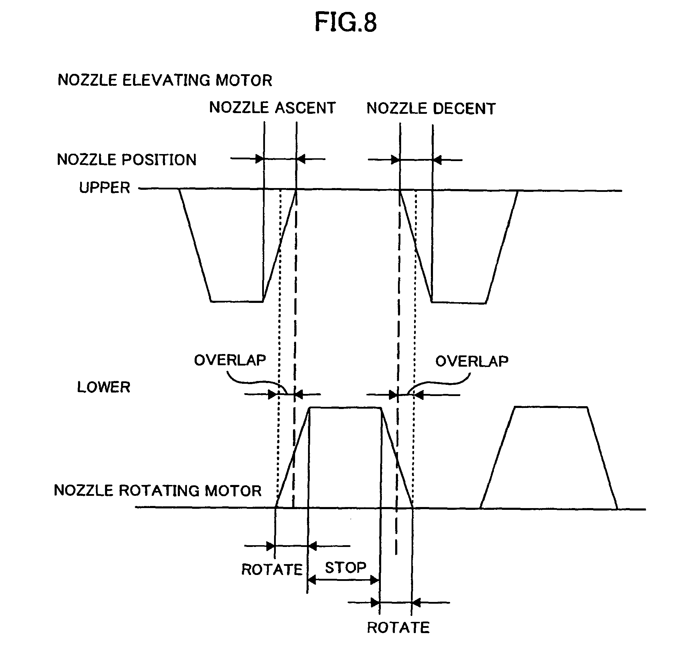

Fig. 8 attached herewith is a view for showing the relationship between the elevating operation of the suction nozzle and the rotating operation of the nozzle rotating motor mentioned above. In "OVERLAP" shown in Fig. 8, the elevating operation of the suction nozzle and the rotating operation of the nozzle rotating motor are executed, at the same time, in parallel with each other. This is because the rotation of the nozzle rotating motor 109 and the rotation of the nozzle rotating motor are executed independently. As was mentioned above, this is because there is no necessity of the motor for use in selection of the suction nozzle, which was applied in the conventional technology, since the electromagnetic clutch is applied in selection of the suction nozzle, wherein there is no member mechanically interfering with each other, and therefore the up/down operation and the revolving operation of the suction nozzle will not be interfered with each other. Herein, since timing when they overlap with each other at the maximum can be determined, uniquely, from the rotating operation of the nozzle rotating motor 109 and the rotating operation of the nozzle elevating motor 102, the CPU 701 outputs a signal for cutting off the movable piece, to the nozzle holder member 301 through the interface and the driver circuit 708, several milliseconds before, so that the nozzle holder member 301 can release the suction nozzle at this timing.

The CPU 701 outputs the signal to the nozzle elevating motor 102, upon basis of this timing, through the interface 714 and the driver circuit 708. Upon basis of this signal, the nozzle elevating motor 102 rotates in such a direction that the first suction nozzle 115 goes down, and due to the rotation of the motive power transmitting member 103, the elevating body 105 and the nozzle base 114 go down, thereby the first suction nozzle 115 goes down toward a predetermined height, i.e., to the height appropriate for it to suck the electronic part "D" from the supply unit 11, which was determined in advance. Thus, due to the θ rotation of the rotor 110, as the nozzle supporting body, and the decent of the nozzle base 114, the first suction nozzle 115 rotates and also goes down, and then the first suction nozzle 115 reaches to the sucking position 151, and also goes down to the height suitable to suck the electronic part "D" thereon.

In this manner, during the rotation of the first suction nozzle 115 to the suction position 151, the first suction nozzle 115 starts the descent thereof. Thus, since the rotation to the suction position 151 and the descent of the first suction nozzle 115 are conducted in parallel with, it is possible to shorten the time necessary for the sucking operation of the electronic part "D", and as a result of this, it is possible to shorten the installation time of the electronic parts onto the printed circuit board. The rotation and the descent of this suction nozzle 115 start during the movement of the installation head actuator 9 in X and Y directions.

However, it is also possible to execute the sucking operation, further quicker much more than the operation of the suction nozzle 115 as was mentioned above, and explanation will be made on a method thereof.

With a distance "PCD", being defined between the suction nozzles 115 facing to each other when the suction nozzles 115 are disposed on circumference of a circle around the center "C" of the installation head actuator 9 is, i.e., a diameter shown in Fig. 7, it is possible to allow two (2) pieces of suction nozzles locating above the suction position 151 to go down, at the same time, by designing this "PCD" to the distance equal to an interval between a plural number of parts takeout openings of the parts supply unit 11, which are aligned in parallel, and by building up the nozzle elevating mechanism as was mentioned above.

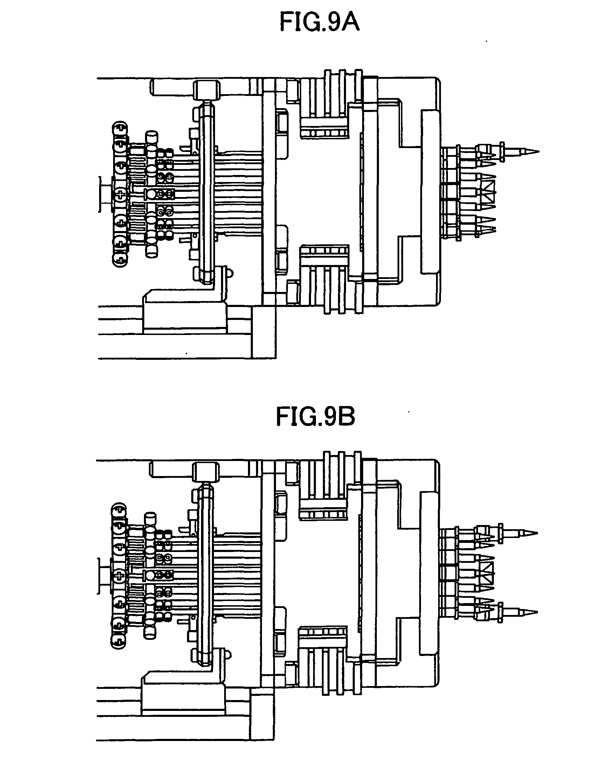

Figs. 9A and 9B are views for showing the decent of the suction nozzle mentioned above Figs. 9A and 9B attached herewith a view for showing the descent of the suction nozzle mentioned above. As is shown in Fig. 9A, not taking out the electronic parts "D" one by one, as in the conventional art, but as is shown in Fig. 9B, two (2) of them are taken out, at the same time, and with this, it is possible to reduce the number of times of the sucking operations down to a half (1/2) of that of the conventional art. This operation is called, "simultaneous suction", and during when executing this simultaneous suction, it is also possible to execute the up/down operation of the nozzle and the rotating operation of the nozzle. In this manner, further, it is possible to increase the throughput of the electronic parts installation device 1.

The light receiving units 116 of the line sensor unit 111 are provided at a position, shifting from the suction position 151 shown in Fig. 7 by 45°, for example, and when the suction nozzle 115 sucking the electronic part "D" thereon passes through a detection position 152 shown in Fig. 6, as was mentioned above, by means of the line sensor unit 111 are executed the detection of presence/absence of the electronic parts "D" and the detection of sucking posture thereof, etc., at a lower end of the suction nozzles 115.

And, when detecting that the part is sucked on a surface, but not to be sucked on, i.e., so-called a standing condition, or it is sucked obliquely, then the installation head actuator 9 and the suction nozzles 115 are moved to an upper portion of a discharge box, so as to let them to fall the electronic parts "D" therein, and a recovery operation is executed, for the same electronic parts "D", again. Further, when detecting that the part is in a normal sucking posture, then the vacuum suction is maintained, and also, since a lower end level (i.e., the lower end position) of that electronic part "D", for correcting unevenness due to a margin or tolerance of the part, the CPU 701 controls the nozzle elevating motor 102, so as to change a decent stroke of the suction nozzle 115 depending on the lower end level mentioned above, when it installs the parts onto the printed circuit board "P".

The elevating body 105 goes down by rotating the motive power transmitting member 103 by a predetermined angle while driving and controlling the nozzle elevating motor 102, and due to the descent of the nozzle base 114, the suction nozzles 115 goes down by the predetermined stroke for the purpose of sucking the electronic parts "D" thereon.

However, when the plural number of the suction nozzles 115 are twelve (12) pieces, for example, the last suction nozzle 115, i.e., a twelfth (12^{th}) suction nozzle 115 is at the suction position 151, when it suck the electronic part "D" thereon, and an eleventh (11^{th}) suction nozzle 115 before that is at a stoppage position 153 next to that suction position. For this reason, the CPU 701 outputs a signal to the nozzle rotating motor 109, so as to rotate the rotor 110 by 30°, two (2) times for each time, intermittently. As a result of this, firstly the electronic part "D" held by the eleventh (11^{th}) suction nozzle 115 passes through the detection position 152, and then the detection of presence/absence of the electronic parts "D" and the detection of the sucking posture thereof, by means of the line sensor unit 111. Next, the electronic part "D" held by the twelfth (12^{th}) suction nozzle 115 passes through the detection position 152, and then in the similar manner, the detection of presence/absence of the electronic parts "D" and the detection of the sucking posture thereof, by means of the line sensor unit 111, and thereby finishing the detection of presence/absence of the electronic parts "D" and the detection of the sucking posture thereof, on all of the suction nozzles 115.

As wasmentionedabove, after finishing the sucking operation of the electronic part "D" by each of the suction nozzles 115 and also the detection of presence/absence of the electronic parts "D" and the detection of the sucking posture thereof on the suction nozzles 115, etc., then the CPU 701 produces the installation sequence data. Also, if the electronic part "D" held by the each suction nozzles 115 is thick, for example, the CPU 701 outputs a signal, so as to rise up the installation head actuators 9, i.e., the installation head body 7, so that that electronic part "D" falls with in a range of a focus of the part recognition camera, when recognizing the parts by means of the part recognition camera, which will be mentioned later. Upon basis of this signal, the head elevating motor rotates into the direction opposite to when the head body goes down. As a result of this, with the functions of the motive power transmitting member 103 and an elevation nut, the installation head body 7 stars a rising thereof, and goes up to a predetermined height, i.e., such a height that the electronic parts "D" fall within the range of the focus of the part recognition camera.

However, if the electronic part "D" held by the each suction nozzle is thin, for example, and the electronic part "D" falls within the range of the focus of the recognition camera, under the condition that the each suction nozzle 115 goes up, no operation is execute to rise up the installation head body 7.

In this manner, within the electronic parts installation device 1, since it is possible, not only to elevate the each suction nozzle 115, but also adjust the height, at which the suction nozzles 115 sucks the part to hold thereon, through the elevation of the installation head body 7 by the operation of a head elevating device, and also since a range of that adjustment can be expanded, therefore it is possible to widen a range of the electronic parts "D", which can be sucked by the installation head body 7 to be installed on the printed circuit board "P".

In case when such rising operation as mentioned above is execute, at the time when this rising operation is started, or in case when such rising operation as mentioned above is not execute, after the last suction nozzle 115 determined sucks the electronic part "D" and holds it thereon, the CPU 701 outputs a signal, so that the installation head actuator 9 moves to the installation coordinate position on the printed circuit board "P", which is positioned by the positioning unit 5, passing above the part recognition camera. With the signal from the CPU 701 is controlled the linear motor, each of the beams 8 moves along the pair of the guides, being driven by the linear motor 21 through the driver circuit 708, in the Y-direction, and each installation head body 7 moves along the guide 13, being driven by the linear motor through the driver circuit 708, in the similar manner, in the X-direction.

During the movement of the installation head body 7, the installation head actuators 9 pass by above the part recognition camera, and the part recognition camera executes a simultaneous photographing of all the parts sucked by the installation head actuators 9, and also taking-in of images thereof, in a "beam non-stop collective fly recognition", and starts apart recognition process by a part recognition processor unit 706.

And, when a recognition result of the installation part of a first article is calculated by the part recognition processor unit 706, then determination is made on whether the movement has been completed or not, up to the coordinate position, i.e., the coordinate position to be installed (i.e., the position of the installation data before correcting the part sucking shift) of the electronic part "D" to be installed first, which is set as a target value of the movement, and when it is completed, the beam 8 mentioned above is started to move while resetting the target value of movement by adding the recognition (or correction) result thereto, on the other hand when it is not completed, the target value of movement is treated by a dynamic change process, i.e., it is amended, dynamically, from the set target value of movement into a target value obtained by adding the recognition (or, correction) result thereto.

Also, upon basis of the recognition result by the part recognition processor unit 706, the CPU 701 calculates out a suction angle or the like, for the electronic part "D" to the each suction nozzle 115. And, within the CPU 701 is compared the calculation result with the installation angle in the installation data memorized within the RAM 702, and if there is a difference between the suction angle calculated and the installation angle, the CPU 701 outputs such a signal to the nozzle rotating motor 109 that the angles are coincident with each other. With this output signal, the nozzle rotating motor 109 starts the rotation thereof during when the installation head body 7 moves to the above the printed circuit board "P", and with this rotation, a part sucking angle by the suction nozzle 115 is brought to coincide with the installation angle.

The installation head body 7 continues the movement thereof even after it passes by above the part recognition camera; however, when the installation head body 7 is in the condition of rising, as was mentioned above, the CPU 701 outputs a signal for brining the installation head body 7 to go down, during the movement thereof . Then, upon basis of this signal, the head elevating motor rotates, and due to the rotation of the motive power transmitting member, the installation head body 7 goes down to the height before it goes up, so that the installation head body 7 reaches on the printed circuit board, and thereby it installs the first electronic part "D" among the electronic parts "D" on the printed circuit board "P".

Hereinafter, explanation will be made on the installing operation of the electronic parts "D" onto the printed circuit board "P" by the suction nozzles 115. However, within the explanation given below, the explanation will be given by assuming that an order of installations by each of the suction nozzles 115 is same to the order of suctions mentioned above.

Thus, due to the movement of the installation head body 7, the first electronic part "D", which is sucked and held by the first suction nozzle 115, reached to the installation coordinate position, and then depending on the thickness of this electronic part "D" and depending on the detection value of the lower end level of that electronic part "D", the suction nozzle 115 is brought to go down by a predetermined stroke when installing it on the printed circuit board "P", thereby installing the electronic part "D" on the printed circuit board "P".

When conducting this installation, the CPU 701 outputs a signal for bringing the suction nozzle 115 to go down, in the similar manner when conducting the sucking operation of the electronic part "D" mentioned above. Upon this signal, the nozzle elevating motor 102 rotates in the direction for brining the first suction nozzle 115 to go down, and due to the rotation of the motive power transmitting member 103, the elevating body 105 goes down depending on the detection value of the lower end level of that electronic part "D", which is detected by the line sensor unit 111 mentioned above, so as to let the suction nozzle 115 go down by the predetermined stroke, i.e. to install the electronic part "D" on the printed circuit board "P".

Also, when the suction nozzle 115 goes down, a solenoid valve (i.e., the air exchanger valve) 308 corresponding to the first suction nozzle 115 is switched from the conduction condition to non-conduction condition upon basis of the signal from the CPU 701, so as to cut off the vacuum source, and then the first suction nozzle 115 stops the vacuum sucking operation thereof. And, an air from the air supply source is blown into an inner passage of the first suction nozzle 115 through an air passage and a nozzle communication passage.

The CPU 701, next, executes a calculation process of the installing operation of the electronic parts "D" to be installed, and repeats that installing operation until when completing all installations of the electronic parts "D", which are sucked in series. Thus, obtaining a result of the recognition process by the part recognition processor unit 706, the CPU 701 executes a process for calculating the movement directions X and Y and a movement target value of the rotation angle "θ", and it drives the linear motor 21 by adding an amount of shifting or deviation, so as to move the beam 8 into the Y-direction, and also drives the nozzle rotating motor 109 so as to rotate the rotor by "θ", thereby revolving the suction nozzle 115 and rotating the nozzle elevating motor 102. With this, that suction nozzle 115 is caused to go down by the predetermined stroke depending on the thickness of that part "D" to install the electronic part "D" on the printed circuit board "P", and after this installation, the suction nozzle 115 does up, and herein after, repeating this, in the similar manner, until completion of the installations of all the electronic parts "D", which are sucked and held by each of the suction nozzles 115 of that installation head actuator 9.

During the time of installation of the electronic part "D" that is conducted in the manner mentioned above, in case where the installation angle does not change in the installations, which will be executed, sequentially, the rotor 110 rotates by a predetermined angle every time when the installing operation is finished, i.e., by 30°, by each, and the suction nozzle 115 is positioned, sequentially, at a predetermined angle, i.e., at the position being same to the sucking position 151 shown in Fig. 6, and at that position is executed the elevation of the suction nozzle 115.

Also, when installing the electronic parts "D", in case where the suction angle of the electronic part "D" on the suction nozzle 115 differs from the installation angle of the electronic part "D" when it is installed, or where the suction angle is shifted from the installation angle, which is determined, upon recognition of the electronic part "D" by the part recognition camera, etc., the rotor 110 is caused to rotate an angle differing from the predetermined angle mentioned above.

Thus, also in case where the suction angle of the electronic part "D" sucked by the suction nozzle 115 differs from the installation angle, and for this reason, the rotor 110 is rotated, since the nozzle holder member base 306 also rotates together with, then it is possible to coincide with the position corresponding to the elevating suction nozzle 115. Therefore, with the elevation of the suction nozzle 115, it is possible to conduct the installation of the electronic part "D" onto the printed circuit board, with certainty, and further to increase accuracy when installing.

However, the explanation about suction and installation of the electronic parts "D" mentioned above was given on the operations of sucking and installing by means of one (1) set of the installation head body 7, among four (4) sets of the installation head bodies 7 , which are equipped with the electronic parts installation device 1, but in the similar manner, the suction and the installation of the electronic parts "D" are executed with other installation head bodies 7.

And, the CPU 701 confirms on whether a part carry-away confirmation function is set or not, and when that part carry-away confirmation function is not set, i.e., when no setup contents of the part carry-away confirmation function is stored in the RAM 702, it executes the operation of sucking the electronic parts in accordance with the next installation data, as was mentioned above.

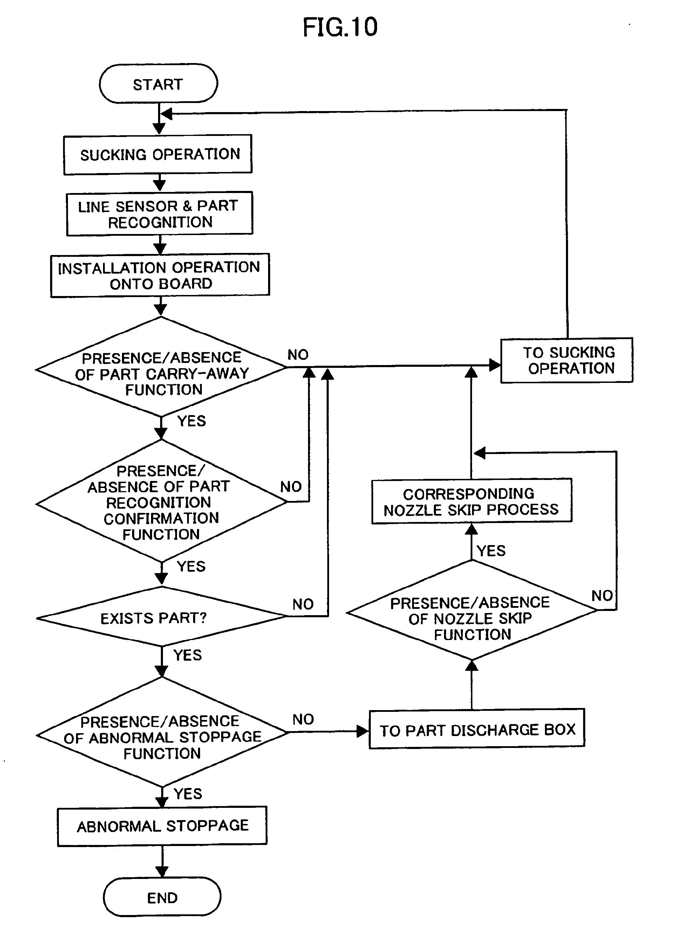

Fig. 10 is a view for showing a flowchart of an electronic part carry-away operation. Herein, the part carry-away confirmation function means a function of conducting a disposal operation upon the electronic parts "D" moving above the discharge box, but not installed at the predetermined position, for example, because of any abnormality.

First of all, as was mentioned above, upon an instruction of the CPU 701, the sucking operation is executed on the electronic part "D" by the suction nozzle 115, and after conducting the detection of presence/absence and the sucking posture of the electronic parts "D" by means of the line sensor unit 111, the installing operation is executed on the printed circuit board. This installing operation is repeated until when all of the installations of the electronic parts "D" sucked in series.

Next, the CPU 701 confirms on whether the setup contents of the part carry-away confirmation function is stored or not within the RAM 702. If it is stored, the CPU 701 confirms on whether a confirmation function is set or not, upon the electronic parts "D" by means of the line sensor unit 111, and if there is not stored the setup contents of the confirmation function of the electronic parts "D" by means of the line sensor unit 111, within the RAM 702, then it executes the operation of sucking the electronic parts in accordance with the next installation data, as was mentioned above. And, in case if there is stored the setup contents of the confirmation function of the electronic parts "D" by means of the line sensor unit 111 therein, on the way of movement of that installation head actuator 9 to each of the part supply units 3 storing the electronic parts "D" to be installed next, the detection of presence/absence of the electronic part "D" is conducted by the line sensor unit 111 while rotating the rotor 110 as was mentioned before.

Upon the detection of presence/absence of the electronic parts "D" by means of the lines sensor unit 111, if all of the suction nozzles 115 are "NO", the CPU 701 shifts into the sucking operation of the electronic parts "D" to be installed next, on the other hand, if there is "YES", even one, among the suction nozzles 115, the CPU 701 confirms on whether the setup contents of an abnormal stoppage function is stored or not, within the RAM 702, and if there is stored the setup contents of the an abnormal stoppage function, the CPU 701 controls so that the electronic parts installation device 1 stops the installing operation thereof, but if there is not stored the setup contents of the an abnormal stoppage function, it executes the disposal operation of the electronic parts "D" while moving them above the discharge box. And, after conducting this disposal operation, the CPU 701 confirms on whether the setup contents of a nozzle skip function are stored nor not, within the RAM 702, and if they are not stored therein, it shifts into the sucking operation of the electronic part "D" to be installed next, but if they are stored, it executes a process of skipping that suction nozzle 115, and shifts into the sucking operation of the electronic part "D" to be installed next.

Thus, onto that installation head actuator 9 are attached the twelve (12) pieces of the suction nozzles 115, however in case where the same kind of suction nozzles 115 are attached thereto, the CPU 701 controls, not using the suction nozzle 115 conducting the carry-away, but in order to use other one of the same kind suction nozzles 115.

And, if all of the electronic parts "D", which are designated by the installation data, are not yet installed on the printed circuit board "P", as was mentioned above, the suction sequence data is produced, again, so as to execute the suctions and the taking out operations of the electronic parts "D", and also the part recognition process, thereby executing the installing operation. However, in case where all of the electronic parts "D", designated by the installation data are already installed on the printed circuit board "P", the printed circuit board "P", upon which the installations are completed, is transferred to the discharge conveyer 6, while turning back the beam 8 mentioned above to an original point, and thereby finishing.

Only mentioning about the operations; differing from the case of conducting the carry-away of the electronic part "D" while detecting it by only the line sensor unit 111, first of all, the printed circuit board "P" is carried into the positioning unit 5 to be positioned therein, while the CPU 701 produces the suction sequence data from the installation data stored within the RAM 702. And, during the movement of the beam 8 from a part suction to a part installation, which will be mentioned later, the part recognition camera picks up an image, so as to execute a process "beam non-stop collective fly recognition", and thereby enabling a simultaneous capture of all the electronic parts "D", which are sucked and held by the respective suction nozzles 115 of the installation head actuator 9.

And, in accordance with the installation data or the like, the suction nozzle 115 sucks the electronic part "D" to be installed from the predetermined part supply unit 11, thereby taking it out. After sucking and holding the electronic part "D", the suction nozzle 115 goes up due to rotation of the nozzle elevating motor 102, and through driving of the nozzle rotating motor 109 is rotated the rotor 110, thereby to rotate the suction nozzle 115, wherein the sucked electronic part "D" positions between a reflector 44 and a light receiving unit 46 during the rotation thereof, therefore the detection of presence/absence and the detection of sucking posture of the part, etc., are executed by the line sensor unit 111.

And, when the part is detected to be in the normal sucking posture, then the vacuum suction is maintained, and since it is possible to detect the lower end level of that electronic part "D", the CPU 701 controls the nozzle elevating motor 102, so that the decent stroke of the suction nozzle 115 changes depending on the lower end level mentioned above when it installs the part onto the printed circuit board, for the purpose of correcting the unevenness in thickness of the part due to the part tolerance.

Hereinafter, a multi-series suction (i.e., sucking the electronic parts "D" as many as possible, continuously) is conducted, one by one, in the similar manner, however when this suction is completed, the CPU 701 produces the installation sequence data, and the beam 8 and the installation head body 7 mentioned above move to the first installation coordinate position where the installation should be done onto the printed circuit board "P".

And, when deciding that it reaches to a timing for the part recognition cameras to pick up an image, the CPU 701 executes the simultaneous photographing and the capture of that images of all the parts "D" sucked by the right and the left installation head actuators 9, in the "beam non-stop collective fly recognition" process, during when the part recognition camera moves the bam 8, and starts the part recognition process by means of the part recognition processor unit 706.

Shortly, when the movement of the beam 8 mentioned above is completed, a first electronic part "D" is installed on the printed circuit board "P" among the electronic parts "D". The CPU 701, next, executes the calculation process for the installing operations of the electronic parts "D" to be installed next, and repeats that installing operations until when the installations is completed for all of the electronic parts "D", which are sucked in series.

And, the CPU701 confirms on whether the part carrying-away confirmation function is set up or not, and if the part carrying-away confirmation function is not set up, i.e., no setup contents of the part carrying-away confirmation function is stored in the RAM 702, for example, it executes the operation of sucking the electronic parts in accordance with the next installation data, as was mentioned above.

Herein, if the setup contents of the part carrying-away confirmation function is stored in the RAM 702, the CPU 701 confirms on whether the confirmation function is set or not, of the electronic parts "D" by the part recognition camera and the part recognition processor unit 706, while if no setup contents of this confirmation function is stored in the RAM 702, it executes the operation of sucking the electronic parts in accordance with the next installation data, as was mentioned above. And, if there is stored the setup contents of the electronic parts "D" by the part recognition camera and the part recognition processor unit 706, the recognition camera picks up an image, on the way of movement of the suction nozzle 115 of that suction head actuator 9 to each of the part supply units 3 storing therein the electronic part "D" to be installed next, and upon this image picked up, the part recognition processor unit 706 executes the recognition process, thereby conducting the detection of presence/absence of the electronic parts "D" after the installation thereof.

Upon detection of presence/absence of the electronic parts "D" by the part recognition camera and the part recognition processor unit 706, if "NO", the step is shifted to the operation of sucking the electronic parts "D" to be installed next, on the contrary if "YES", the CPU 701 confirms on whether the setup contents of the abnormal stoppage function is stored or not, within the RAM 702, and if there is stored the setup contents of the abnormal stoppage function, then the CPU 701 controls to stop the installing operation of the electronic parts installation device 1, while if there is not stored the setup contents of the abnormal stoppage function, it moves the nozzle above the discharge box, so as to execute the disposal operation of the electronic part "D".

And, after conducting this disposal, the CPU 701 confirms on whether the setup contents of the nozzle skip function is stored or not, within the RAM 702, and if there is not stored, then the step is shifted into the operation of sucking the electronic part "D" to be installed next, while if there is stored, the skip process is executed for the corresponding suction nozzle 115, and the step is shifted into the operation of sucking the electronic part "D" to be installed next.

Thus, onto that installation head actuator 9 are attached the twelve (12) pieces of the suction nozzles 115, however in case where the same kind of suction nozzles 115 are attached thereto, the CPU 701 controls, not using the suction nozzle 115 conducting the carry-away, but in order to use other one of the same kind suction nozzles 115.

And, if all of the electronic parts "D", which are designated by the installation data, are not yet installed on the printed circuit board "P", as was mentioned above, the suction sequence data is produced, again, so as to execute the suctions and the taking out operations of the electronic parts "D", and also the part recognition process, thereby executing the installing operation. However, in case where all of the electronic parts "D", designated by the installation data are already installed on the printed circuit board "P", the printed circuit board "P", upon which the installations are completed, is transferred to the discharge conveyer 6, while turning back the beam 8 mentioned above to an original point, and thereby finishing.

However, on the way of the installation head body 7 moves to the part installation position, when it goes down to the height before it goes up, before the part recognition, an amount of that descent changes depending on the thickness of the electronic part "D" held the suction nozzle 115, the height of shoot of the positioning unit 5, or the height of the electronic part "D", which was already installed on the printed circuit board "P", etc., and for example, when the electronic part "D" held by the suction nozzle 115 is thick, the descent amount is controlled to be small. In this manner, it is possible to adjust the descent amount of the installation head body 7, of course, and it is also possible to enlarge an amount of rising of the electronic part "D" held by the suction nozzle 115, with rising of the suction nozzle 115 and rising of the installation head body 7, such as, when it is necessary to rise up the electronic part "D" held by the suction nozzle 115 due to the relationship between the height of the electronic part "D", which was already installed on the printed circuit board "P", etc., and thereby it is also possible to expand the range of the thickness of the electronic parts "D" installable, comparing to the case when elevating only the suction nozzles 115.

Also, within the embodiment mentioned above, although the explanation was given only upon the electronic parts installation device 1, wherein two (2) sets of the installation head bodies 7 are provided to be able to slide freely, on each of two (2) pieces of the beams 8, independently, however for example, also within the electronic parts installation device disposing four (4) pieces of the beams, each being able to slide freely, independently, in the front and the back and the left-hand side and the right-hand side, respectively, it is possible to obtain the similar function and effect, by constructing the installation head bodies in the similar manner to the embodiment mentioned above.

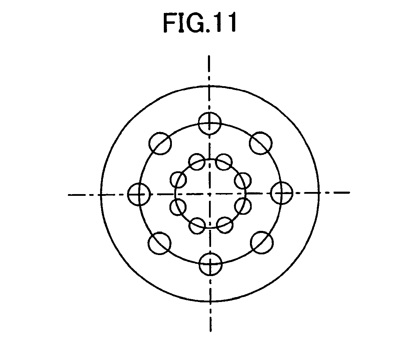

Also, in the embodiment mentioned above, although the explanation was made about the installation head actuators, on each of which the suction nozzles 115 are disposed on a ring, circularly, but as is shown in Fig. 11, the suction nozzles 115 may be disposed on the rings more than two (2), circularly.

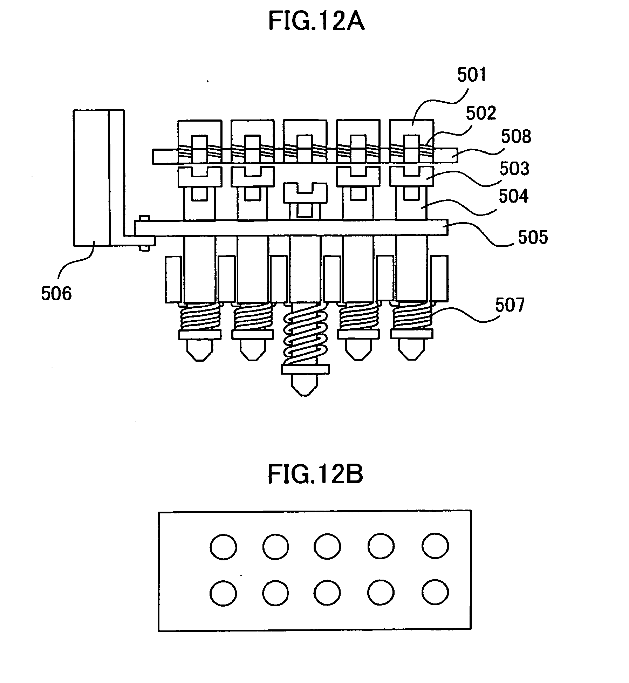

Also, as is shown in Figs. 12A and 12B, the suction nozzles may be disposed on one (1) line or a plural number of lines, linearly. Fig. 12A is a front cross-section view of the suction nozzles, which are aligned on one (1) line, linearly. Fig. 12B is a bottom view of the suction nozzles, which are aligned on two (2) lines, linearly. Onto a nozzle holder member 508 is attached other nozzle holder member 501, and a movable piece 503, which is attached on an upper portion of the suction nozzle 504 is attracted to the nozzle holder member 501. On that nozzle holder member is mounted a permanent magnet not shown in the figure, and with using the magnetic flux generated by this permanent magnet, the movable piece is absorbed. Generating the magnetic flux, by applying current into an exiting coil 502 wound around the nozzle holder member 501, in the opposite direction to the magnetic flux generated by the permanent magnet, i.e., through neutralization, it is possible to separate the movable piece 503 of a predetermined suction nozzle 504, at an arbitrary moment. And, the nozzle 504 separated from, since it is biased downward by a spring 507, is pushed down on a nozzle base 505, and depending on elevation of an nozzle elevating body 506, the predetermined suction nozzle 504 separated goes up and down.

Heretofore, the explanation was made about the embodiments of the present invention, however for the person skilled in the art, it is possible to make various alternations, changes or modifications, upon basis of the explanation mentioned above, and therefore the present invention should include such alternations, changes or modifications as mentioned above without departing from the gist of the invention.

As was mentioned above, in details thereof, according to the present invention, it is possible to provide an electronic parts installation device, for increasing the throughput by conducting a rotating operation for revolving the suction nozzle to a predetermined position and an elevating operation for moving the suction nozzles in up/down directions, simultaneously, in parallel with, and having high reliability by reducing contacts and/or interferences generating during the parallel operation.

## Claims

1. An electronic parts installation head actuator, comprising:
a plural number of suction nozzles (115), each of which is configured to suck an electronic part to install it on a printed circuit board;
a nozzle selector member (301), which is configured to hold said plural number of suction nozzles (115) and to select a predetermined suction nozzle (115); and
an elevating device (101), which is configured to elevate said plural number of suction nozzles (115), wherein
said nozzle selector member (301) is configured to detache said predetermined suction nozzle (115) electro-magnetically from said plural number of suction nozzles (115) when said predetermined nozzle (115) is selected, and thereby conducts selecting, and wherein
the predetermined suction nozzle (115) is provided with an elastic body (112) for biasing the suction nozzle (115) in a downward direction; **characterized in that**
said nozzle selector member (301) has a permanent magnet attracting said suction nozzle (115), which is biased in said downward direction by said elastic body (112), into an upward direction opposite to said downward direction, and an exciting coil (311) for neutralizing the magnetic force of said permanent magnet by applying current therein.

2. The electronic parts installation head actuator, as described in the claim 1, wherein
said plural number of suction nozzles (115) are disposed on one ring or a plural number of rings, circularly.

3. The electronic parts installation head actuator, as described in any one of the claims 1 to 2, further comprising:
a nozzle support member, which is configured to support said plural number of suction nozzles (115); and
a rotating device (110), which is configured to rotate said nozzle support member a vertical axial line.

4. The electronic parts installation head actuator, as described in the claim 3, wherein
said elevating device (101) and said rotating device (110) are operated, simultaneously, and thereby enabling parallel operation thereof.

5. The electronic parts installation head actuator, as described in the claim 1, wherein
said plural number of suction nozzles (115) are disposed on one line or a plural number of lines, linearly.

6. An electronic parts installation device, comprising:
a plural number of parts supply units (11), each of which is configured to supply an electronic part at a part sucking position;
a beam (8) movable between each part supply unit and a printed circuit board; and
an electronic parts installation head actuator (9), being movable along said bean and movable in X-Y direction, wherein
said electronic parts installation head actuator (9) is the electronic parts installation actuator described in any one of the claims 1 to 4.

7. An electronic parts installation device, comprising:
a plural number of parts supply units (11), each of which is configured to supply an electronic part at a part sucking position;
a beam movable between each part supply unit (11) and a printed circuit board (P); and
an electronic parts installation head actuator (9), being movable along said bean and movable in X-Y direction, wherein
said electronic parts installation head actuator (9) is the electronic parts installation actuator described in the claim 5.

## Patentansprüche

1. Installationskopfaktuator für elektronische Bauteile, mit:
mehreren Saugdüsen (115), von denen jede dazu konfiguriert ist, ein elektronisches Bauteil anzusaugen, um es auf einer gedruckten Leiterplatte zu installieren;
einem Düsenauswahlvorrichtungselement (301), das dazu konfiguriert ist, die mehreren Saugdüsen (115) zu halten und eine vorgegebene Saugdüse (115) auszuwählen; und
einer Anhebungsvorrichtung (101), die dazu konfiguriert ist, die mehreren Saugdüsen (115) anzuheben, wobei
das Düsenauswahlvorrichtungselement (301) dazu konfiguriert ist, die vorgegebene Saugdüse (115) elektromagnetisch von den mehreren Saugdüsen (115) zu trennen, wenn die vorgegebene Düse (115) ausgewählt wird, und dadurch ein Auswählen ausführt, und wobei
die vorgegebene Saugdüse (115) mit einem elastischen Körper (112) zum Vorspannen der Saugdüse (115) in einer Abwärtsrichtung versehen ist, **dadurch gekennzeichnet, dass**
das Düsenauswahlvorrichtungselement (301) einen Dauermagneten aufweist, der die Saugdüse (115), die in der Abwärtsrichtung durch den elastischen Körper (112) vorgespannt ist, in eine Aufwärtsrichtung entgegen der Abwärtsrichtung anzieht, und eine Anregungsspule (311) zum Neutralisieren der Magnetkraft des Dauermagneten aufweist, indem an denselben Strom angelegt wird.

2. Installationskopfaktuator für elektronische Bauteile nach Anspruch 1, wobei
die mehreren Saugdüsen (115) auf einem Ring oder mehreren Ringen kreisförmig angeordnet sind.

3. Installationskopfaktuator für elektronische Bauteile nach irgendeinem der Ansprüche 1 und 2, ferner mit:
einem Düsentragelement, das dazu konfiguriert ist, die mehreren Saugdüsen (115) zu tragen; und
einer Drehvorrichtung (110), die dazu konfiguriert ist, das Düsentragelement um eine vertikale axiale Linie zu drehen.

4. Installationskopfaktuator für elektronische Bauteile nach Anspruch 3, wobei
die Anhebungsvorrichtung (101) und die Drehvorrichtung (110) gleichzeitig betrieben werden und dadurch ihre parallele Betätigung ermöglichen.

5. Installationskopfaktuator für elektronische Bauteile nach Anspruch 1, wobei
die mehreren Saugdüsen (115) auf einer Linie oder mehreren Linien linear angeordnet sind.

6. Installationsvorrichtung für elektronische Bauteile, mit:
mehreren Bauteil-Liefereinheiten (11), von denen jede dazu konfiguriert ist, ein elektronisches Bauteil an eine Bauteil-Ansaugposition zu liefern;
einem Balken (8), der zwischen jeder Bauteil-Liefereinheit und einer gedruckten Leiterplatte beweglich ist; und
einem Installationskopfaktuator (9) für elektronische Bauteile, der entlang des Balkens und in einer X-Y-Richtung beweglich ist, wobei
der Installationskopfaktuator (9) für elektronische Bauteile der Installationsaktuator für elektronische Bauteile ist, der in irgendeinem der Ansprüche 1 bis 4 beschrieben ist.

7. Installationsvorrichtung für elektronische Bauteile, mit:
mehreren Bauteil-Liefereinheiten (11), von denen jede dazu konfiguriert ist, ein elektronisches Bauteil an eine Bauteil-Ansaugposition zu liefern;
einem Balken, der zwischen jeder Bauteil-Liefereinheit (11) und einer gedruckten Leiterplatte (P) beweglich ist; und
einem Installationskopfaktuator (9) für elektronische Bauteile, der entlang des Balkens und in einer X-Y-Richtung beweglich ist, wobei
der Installationskopfaktuator (9) für elektronische Bauteile der Installationsaktuator für elektronische Bauteile ist, der im Anspruch 5 beschrieben ist.

## Revendications

1. Actionneur de tête d'installation de pièces électroniques, comprenant :
un nombre multiple de buses d'aspiration (115), chacune desquelles est configurée pour aspirer une pièce électronique afin de l'installer sur une carte de circuits imprimés ;
un élément sélecteur (301) de buse, qui est configuré pour contenir ledit nombre multiple de buses d'aspiration (115) et pour sélectionner une buse d'aspiration (115) prédéterminée ; et
un dispositif de levage (101), qui est configuré pour lever ledit nombre multiple de buses d'aspiration (115), dans lequel
ledit élément sélecteur (301) de buse est configuré pour détacher ladite buse d'aspiration (115) prédéterminée électromagnétiquement dudit nombre multiple de buses d'aspiration (115) lorsque ladite buse (115) prédéterminée est sélectionnée, et ainsi exécute la sélection, et dans lequel
la buse d'aspiration (115) prédéterminée est prévue avec un corps élastique (112) pour pousser la buse d'aspiration (115) dans un sens vers le bas ; **caractérisé en ce que**
ledit élément sélecteur (301) de buse a un aimant permanent attirant ladite buse d'aspiration (115), qui est poussée dans ledit sens vers le bas par ledit corps élastique (112), dans un sens vers le haut opposé audit sens vers le bas, et une bobine d'excitation (311) pour neutraliser la force magnétique dudit aimant permanent en appliquant un courant à celle-ci.

2. Actionneur de tête d'installation de pièces électroniques selon la revendication 1, dans lequel
ledit nombre multiple de buses d'aspiration (115) sont disposées sur une couronne ou un nombre multiple de couronnes, circulairement.

3. Actionneur de tête d'installation de pièces électroniques selon l'une quelconque des revendications 1 à 2, comprenant en outre :
un élément support de buses, qui est configuré pour supporter ledit nombre multiple de buses d'aspiration (115) ; et
un dispositif rotatif (110), qui est configuré pour faire tourner ledit élément support de buses autour d'une ligne axiale verticale.

4. Actionneur de tête d'installation de pièces électroniques selon la revendication 3, dans lequel
ledit dispositif de levage (101) et ledit dispositif rotatif (110) sont utilisés, simultanément, et permettant ainsi un fonctionnement en parallèle de ceux-ci.

5. Actionneur de tête d'installation de pièces électroniques selon la revendication 1, dans lequel
ledit nombre multiple de buses d'aspiration (115) sont disposées sur une ligne ou un nombre multiple de lignes, linéairement.

6. Dispositif d'installation de pièces électroniques, comprenant :
un nombre multiple d'unités (11) de transfert de pièces, chacune desquelles est configurée pour transférer une pièce électronique en une position d'aspiration de pièce ;
un longeron (8) mobile entre chaque unité de transfert de pièce et une carte de circuits imprimés ; et
un actionneur de tête d'installation de pièces électroniques (9), étant mobile le long dudit longeron et mobile dans le sens X-Y, dans lequel
ledit actionneur de tête d'installation de pièces électroniques (9) est l'actionneur d'installation de pièces électroniques selon l'une quelconque des revendications 1 à 4.

7. Dispositif d'installation de pièces électroniques, comprenant :
un nombre multiple d'unités (11) de transfert de pièces, chacune desquelles est configurée pour transférer une pièce électronique en une position d'aspiration de pièce ;
un longeron mobile entre chaque unité (11) de transfert de pièce et une carte de circuits imprimés (P) ; et
un actionneur de tête d'installation de pièces électroniques (9), étant mobile le long dudit longeron et mobile dans le sens X-Y, dans lequel
ledit actionneur de tête d'installation de pièces électroniques (9) est l'actionneur d'installation de pièces électroniques selon la revendication 5.
